# EUROPEAN PATENT APPLICATION

(11) **EP 4 130 832 A1**
(43) Date of publication of application: **08.02.2023**
(21) Application number: 20938945.1
(22) Date of filing: 30.06.2020
(51) Int. Cl.: G02B 7/02

(54) **CAMERA MODULE AND ASSEMBLING METHOD**

(30) Priority: 01.06.2020 CN 202010486713
(71) Applicant: Zhejiang Sunny Smartlead Technologies Co., Ltd., Yuyao, Zheijiang 315400 (CN)
(72) Inventor: ZHANG, Kouwen, Zhejiang 315400 (CN); LIU, Zhaoqing, Zhejiang 315400 (CN); XU, Yinfeng, Zhejiang 315400 (CN); NONG, Kaixun, Zhejiang 315400 (CN); ZHOU, Dichang, Zhejiang 315400 (CN)
(74) Representative: Lermer, Christoph
(86) International application number: PCT/CN2020/099083
(87) International publication number: WO 2021/243778

(57) **Abstract**

A camera module and an assembling method. The camera module comprises a lens (1), a connecting member (2), a circuit board (3), and a photoelectric imaging sensor provided on the circuit board (3). Along the direction of an optical axis, the connecting member (2) comprises a first connecting portion (21) fixedly connected to the lens (1) and a second connecting portion (22) connected to the circuit board (3); a correction plane (4) is provided on one side, facing the second connecting portion (22), of the first connecting portion (21), or a correction plane (4) is provided on one side, close to the circuit board (3), of the second connecting portion (22); the correction plane (4) is parallel to an imaging plane of the lens (1); a connecting adhesive layer (A) having a predetermined thickness is provided between the correction plane (4) and the second connecting portion (22) or between the correction plane (4) and the circuit board (3). The camera module can ensure that the thickness of the filled glue is consistent in the AA manufacture procedure, and the shrinkage amount of the glue is consistent, thereby improving the consistency and qualified rate of products.

## Description

### CROSS-REFERENCE TO RELATED APPLICATIONS

The present application claims priority to Chinese patent application No. 202010486713.9, titled "CAMERA MODULE AND ASSEMBLING METHOD", filed with the Chinese National Intellectual Property Administration on June 1, 2020, the entire disclosure of which is incorporated herein by reference.

### FIELD OF THE INVENTION

The present disclosure belongs to the technical field of optics, and in particular relates to a camera module and an assembling method.

### BACKGROUND

With the continuous development of photoelectric imaging sensors and image processing system platforms, higher and higher demands are imposed on image processing algorithms, making resolutions of cameras become higher and higher. Especially in non-consumer product fields including on-vehicle field and security camera field, low-pixel products have been gradually phased out. With the continuous upgrading of the pixels of the photoelectric imaging sensors, a resolution power of a lens in the camera is required to be higher and higher. However, as compared with the photoelectric imaging sensor, a resolution power margin of the lens becomes smaller and smaller, that is, a focal depth range of a camera module becomes smaller and smaller, which therefore requires the precision of assembling the camera module to be higher. In addition, the camera modules in the non-consumer product fields are all basically fixed-focus modules (non-autofocus). When the temperature changes, an optimal imaging plane of the lens will drift. Moreover, operating temperature conditions of such modules are relatively harsh (for example, a temperature range of -40°C to +85°C is generally required in the on-vehicle field). If it is desired to make the camera module maintain good performance in the full temperature range, the camera module is required to have a higher precision during assembly (not only the performance at normal temperature needs to be ensured, but also back focus temperature drift of the lens under low temperature and high temperature conditions needs to be considered, which makes the assembly margin to be even smaller when assembling at normal temperature).

It can be seen from the above that: 1) as the pixels of the photoelectric imaging sensor are upgraded, the resolution power margin of the lens becomes smaller relative to the photoelectric imaging sensor, and the focal depth range of the module becomes smaller; and 2) for the fixed-focus camera module, the position of back focus of the lens (the optimal imaging plane of the lens) is different under different temperature conditions, that is, when the temperature changes, the camera module will be out of focus. Considering the above two points, when the camera module is being assembled, it is required that the position of the imaging plane of the lens and a photosensitive position of the photoelectric imaging sensor coincide as much as possible and the deviation be as small as possible, that is, a higher precision of assembling the camera module is required.

For cameras that require high-precision assembly, the AA process is generally used in the industry for camera assembling. In the AA process, AA glue is an indispensable key factor: through the AA technology, after the lens and a circuit board are calibrated to the best relative positions, it is the AA glue that connects and fixes the lens and the circuit board or a base so that the lens and the circuit board are finally always kept at the best relative positions (the imaging plane of the lens coincides with a photosensitive surface of the photoelectric imaging sensor on the circuit board). However, the AA glue has a characteristic that it shrinks after curing, and the shrinkage amount is different when the thickness of the glue is different; the larger the thickness of the glue is, the larger the shrinkage amount will be. On the other hand, even if the thickness of the glue is the same, due to the difference in curing conditions (UV exposure curing, thermal curing), the shrinkage amount of the glue will still be different; the larger the thickness of the glue is, the larger the difference in the shrinkage amount will be. For the shrinkage of the glue, this shrinkage amount will usually be taken into consideration, and a fixed compensation amount is preset for compensation in case of the AA process. However, generally, each camera module has a different thickness of the glue, so the shrinkage amount of the glue is also different. As such, when performing the compensation in case of the AA process, the compensation is performed according to the fixed compensation amount. For some camera modules, the compensation is too much, and for some camera modules, the compensation is too little, which will lead to inconsistency of the resolution powers of the camera modules, making it impossible to effectively ensure that the resolution powers of all the camera modules can reach a qualified level. Moreover, for the camera modules requiring extremely high precision of assembling as mentioned above, the traditional technology of AA glue shrinkage amount compensation can no longer meet this extremely high precision requirement. Therefore, for camera modules that require high-precision assembly, solving the inconsistency of AA glue thickness is very critical. It is necessary to implement a certain method to enable good consistency of the glue thickness of the camera modules while keeping the glue thickness small (a smaller glue thickness means a smaller shrinkage amount and a smaller difference in the shrinkage amount), so that the glue shrinkage amount of each module is basically the same, and a fixed compensation amount for glue shrinkage can be used for compensation in case of the AA process.

The reason for the inconsistency of AA glue thickness is due to the deviations of various components of the camera module, the main one of which is the deviation of optical lens (specifically presented as optical back focus deviation and optical axis inclination deviation). The optical lens is assembled by several glasses, and further includes structural parts (spacers, lens barrels, etc.). There are tolerances between all the glasses and the structural parts, which leads to an inconsistent position of an optical focal plane of the optical lens relative to an adhesive surface of the glue, thereby directly resulting in the inconsistent thickness of the glue. In addition, a height deviation of the photoelectric imaging sensor and a height deviation of the base directly affect the size of AA gap, thereby affecting the thickness of the AA glue.

### SUMMARY OF THE INVENTION

An object of the present disclosure is to solve the above problems and provide a camera module and an assembling method, so as to solve the problem that the resolution power cannot be guaranteed due to the inconsistent glue thickness of the same batch of camera modules.

In order to achieve the above object, the present disclosure provides a camera module, which includes a lens, a connector, a circuit board, and a photoelectric imaging sensor arranged on the circuit board; in the direction of an optical axis, the connector includes a first connection part fixedly connected with the lens, and a second connection part connected with the circuit board; a correction plane is provided on a side of the first connection part that faces the second connection part, or a correction plane is provided on a side of the second connection part that is close to the circuit board; the correction plane is parallel with an imaging plane of the lens, and a connection glue layer of a predetermined thickness is provided between the correction plane and the second connection part or between the correction plane and the circuit board.

According to an aspect of the present disclosure, the connection glue layer is provided between the correction plane and the second connection part, and there exists d=F+h-H;
where d represents the thickness of the connection glue layer, F represents a distance from the correction plane to the imaging plane, h represents a height of a photosensitive surface of the photoelectric imaging sensor from an upper surface of the circuit board, and H represents a height of the second connection part.

According to an aspect of the present disclosure, the connection glue layer is provided between the correction plane and the circuit board, and there exists d=F+h;
where d represents the thickness of the connection glue layer, F represents a distance from the correction plane to the imaging plane, and h represents a height of a photosensitive surface of the photoelectric imaging sensor from an upper surface of the circuit board.

According to an aspect of the present disclosure, the second connection part is assembled with the circuit board, and the correction plane is provided on the side of the first connection part that faces the second connection part.

According to an aspect of the present disclosure, the first connection part and the second connection part are integrally formed, and the correction plane is provided on the side of the second connection part that is close to the circuit board.

According to an aspect of the present disclosure, the first connection part is a lens flange, the second connection part is a lens base, the lens is assembled with the second connection part through the first connection part, and the correction plane is provided on the side of the second connection part that is close to the circuit board.

The present disclosure also provides an assembling method for the above-described camera module, which includes the steps of:
S1: assembling the lens with the connector having a size margin;
S2: determining a height h of a photosensitive surface of the photoelectric imaging sensor from an upper surface of the circuit board;
S3: setting the thickness d of the connection glue layer;
S4: determining the imaging plane of the lens; and
S5: according to the value of h obtained in the step S2 and the set value of d, and taking the imaging plane of the lens as a reference, performing material removal processing on the first connection part or the second connection part to obtain the correction plane which is a free end and which is parallel with the imaging plane, and fixing the first connection part and the second connection part through the connection glue layer or fixing the second connection part and the circuit board through the connection glue layer.

According to an aspect of the present disclosure, the assembling method includes:
measuring a height H of the second connection part, and in the direction of the optical axis, assembling the lens with the first connection part, and assembling the circuit board and the second connection part into one component;
measuring the height h of the photosensitive surface of the photoelectric imaging sensor from the upper surface of the circuit board;
setting the thickness d of the connection glue layer;
determining the imaging plane of the lens;
according to the set d and the measured H and h, and taking the imaging plane as a reference, performing material removal processing on the first connection part to obtain the correction plane which is parallel with the imaging plane, and making a distance F from the correction plane to the imaging plane be F=H+d-h; and
fixedly connecting the correction plane of the first connection part and the second connection part through the connection glue layer.

According to an aspect of the present disclosure, the assembling method includes:
in the direction of the optical axis, assembling the lens, the first connection part and the second connection part into one component, or selecting the first connection part and the second connection part as a connector of an integrally formed structure to form one component with the lens;
measuring the height h of the photosensitive surface of the photoelectric imaging sensor from the upper surface of the circuit board;
setting the thickness d of the connection glue layer;
determining the imaging plane of the lens;
according to the set d and the measured h, and taking the imaging plane as a reference, performing material removal processing on the second connection part to obtain the correction plane which is parallel with the imaging plane, and making a distance F from the correction plane to the imaging plane be F=d-h; and
fixedly connecting the circuit board and the correction plane of the second connection part through the connection glue layer.

According to an aspect of the present disclosure, the method of performing material removal processing on the first connection part or the second connection part to obtain the correction plane includes slicing, turning, cutting, milling or chemical etching.

According to a solution of the present disclosure, a correction plane is provided on a side of the first connection part that faces the second connection part, or a correction plane is provided on a side of the second connection part that faces the circuit board; the correction plane is parallel with the imaging plane of the lens, and is perpendicular to the actual optical axis of the lens, so that a gap between a lower side face of the first connection part and the second connection part (the base) is consistent, or a gap between a lower side face of the second connection part and the circuit board is consistent, thereby ensuring that in the AA process, the thickness of the filled glue is consistent, and the shrinkage amount of the glue is consistent, which solves the problem of poor resolution power of the camera module caused by the inconsistent thickness of the filled glue.

In an aspect of the present disclosure, the thickness of the connection glue layer between the correction plane and the second connection part or the circuit board is set to be the same, so that the thickness of the connection glue layer in all the camera modules is the same, and that the shrinkage amounts of all the camera modules are the same, which is advantageous for improving the consistency of the product.

According to a solution of the present disclosure, the connection part of the present disclosure is provided with a sufficient size margin. By sufficient size margin, it means that according to the concept of the present disclosure, for different camera modules, in case that the connection glue layer d is set to be consistent, regardless of what the optical axis deviation angle of the camera module and the position deviation of the imaging plane of the lens are, the corresponding correction plane can be found according to F=H+d-h or F=d-h, and then the material margin is removed to obtain the camera modules of the consistent glue thickness.

### BRIEF DESCRIPTION OF THE DRAWINGS

FIG. 1 schematically shows a structural view of a camera module according to an embodiment of the present disclosure;
FIG. 2 schematically shows an assembly structure view of the camera module in an ideal state;
FIG. 3 schematically shows a view when there is an included angle between the actual optical axis of the lens and a mechanical axis;
FIG. 4 schematically shows an assembly view of the camera module in an actual state;
FIG. 5 schematically shows a view of a correction plane according to the present disclosure;
FIG. 6 schematically shows a view indicating a deviation of the imaging plane of the lens;
FIG. 7 schematically shows a view of required glue thickness when assembling the camera modules corresponding to different imaging plane deviations in FIG. 6;
FIG. 8 schematically shows an assembly view of the camera module according to a second embodiment in an ideal state;
FIG. 9 schematically shows an assembly view of the camera module in an actual state;
FIG. 10 schematically shows a view of the correction plane of the second embodiment;
FIG. 11 schematically shows a structural view of the camera module according to the second embodiment of the present disclosure;
FIG. 12 schematically shows a view of the camera module according to a third embodiment in an ideal state;
FIG. 13 schematically shows a view of the camera module of the third embodiment in an actual state;
FIG. 14 schematically shows a view of the correction plane according to the third embodiment of the present disclosure; and
FIG. 15 schematically shows a structural view of the camera module according to the third embodiment of the present disclosure.

### DETAILED DESCRIPTION OF THE INVENTION

In order to more clearly illustrate the embodiments of the present disclosure or the technical solutions in the prior art, drawings required to be used in the embodiments will be briefly described below. Obviously, the drawings in the following description show only some of the embodiments of the present disclosure, and those skilled in the art can also obtain other drawings based on these drawings without creative efforts.

When describing the embodiments of the present disclosure, the orientations or positional relationships described by the terms "longitudinal", "transverse", "upper", "lower", "front", "rear", "left", "right", "vertical", "horizontal", "top", "bottom", "inner" and "outer" are based on the orientations or positional relationships shown in the related drawings. These terms are merely used for the sake of facilitating describing the present disclosure and simplifying the description, and do not indicate or imply that the device or element involved must have a particular orientation, or must be constructed or operated in a particular orientation. Therefore, the above terms should not be construed as limiting the present disclosure.

The present disclosure will be described in detail below with reference to the drawings and specific embodiments. It is impossible to describe all the embodiments exhaustively herein, but the embodiments of the present disclosure are not limited to the following embodiments.

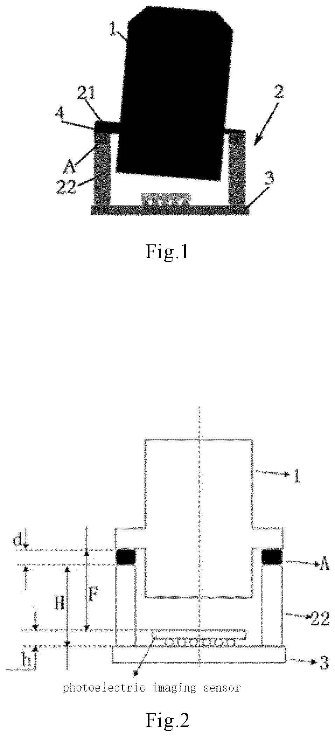

As shown in FIGS. 1, 11 and 15, the camera module of the present disclosure includes a lens 1, a connector 2, a circuit board 3, a photoelectric imaging sensor provided on the circuit board, and a correction plane 4. In the direction of an optical axis, the connector 2 includes a first connection part 21 fixedly connected with the lens, and a second connection part 22 connected with the circuit board 3. According to the concept of the present disclosure, the first connection part 21 and the second connection part 22 are separate members which are connected, or the first connection part 21 and the second connection part 22 are integrally formed. In the present disclosure, the correction plane 4 is provided on a side of the first connection part 21 that faces the second connection part 22, or on a side of the second connection part 22 that faces the circuit board 3. In addition, the correction plane 4 of the present disclosure is parallel with an imaging plane of the lens 1 and perpendicular to the optical axis of the lens 1. According to different embodiments of the present disclosure, a connection glue layer A is provided between the correction plane 4 and the second connection part 22, or a connection glue layer A is provided between the correction plane 4 and the circuit board 3. It should be noted that for all the camera modules, the thickness of the connection glue layer A is set to be the same, that is, when assembling all the camera modules, the thickness of the filled glue used for assembling is consistent.

As shown in FIGS. 1 to 5, according to a first embodiment of the present disclosure, the first connection part 21 and the second connection part 22 of the connector 2 are both separate members. In this embodiment, the first connection part 21 is a connection flange and is fixedly connected with the lens 1, and the second connection part 22 is a lens base. As shown in FIG. 2, in an ideal state, the base is assembled with the circuit board 3, and then the lens 1 is assembled with the base and the circuit board 3 through the AA process. After an optimal imaging position of the lens is found, the glue (the connection glue layer) is filled to fixedly connect the first connection part 21 and the second connection part 22.

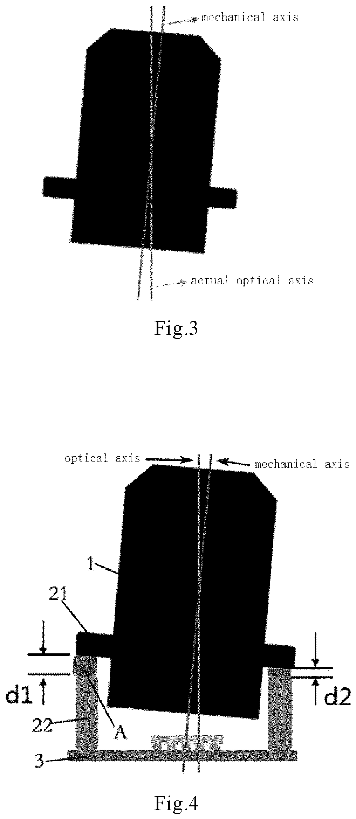

However, as shown in FIGS. 3 and 4, in an actual assembling process of the camera module, there is a certain angle deviation between a mechanical axis of the lens 1 and the actual optical axis, so that the mechanical axis of the lens 1 and the actual optical axis do not coincide with each other. During the assembling process of the camera module, it is necessary to ensure that the actual optical axis of the lens 1 is perpendicular to a photosensitive chip on the circuit board 3 to guarantee the best imaging effect. Therefore, the lens 1 needs to be tilted at a certain angle during assembly to ensure that the actual optical axis is arranged perpendicular to the photosensitive chip. In this state, it will cause a gap between the first connection part 21 (the connection flange) and the second connection part 22 (the base) to be inconsistent in a circumferential direction. As shown in the cross-sectional view of FIG. 4, the gap between the first connection part 21 and a left side of the base 22 is d1, and the gap between the first connection part 21 and a right side of the base 22 is d2, where d1>d2. As a result, the amounts of glue filled on the left and right sides are different when fixing the first connection part 21 and the second connection part 22, and the difference in the amounts of filled glue results in different shrinkage amounts, which in turn affects the resolution power of the camera module.

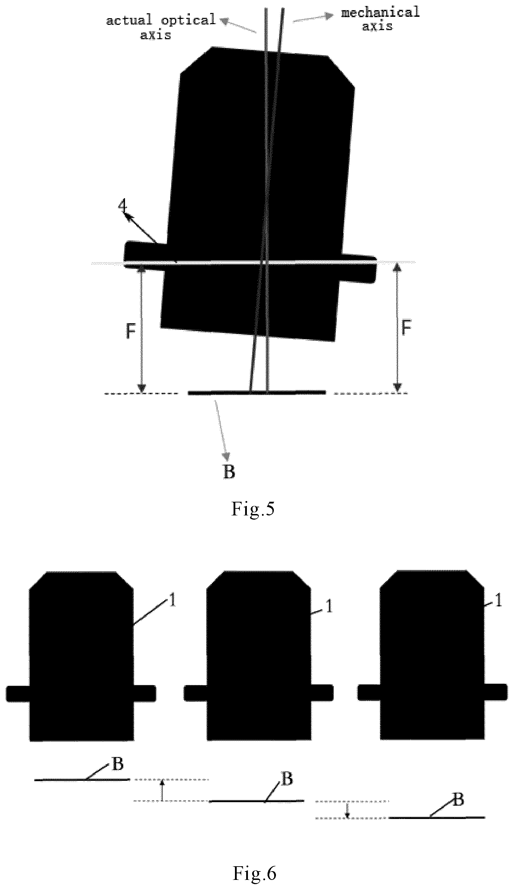

The camera module of the present disclosure solves this problem very well. As shown in FIGS. 1 and 5, in this embodiment, a correction plane 4 is provided on a side of the first connection part 21 that faces the second connection part 22. That is, a lower side face of the first connection part 21 is the correction plane 4, and the correction plane 4 is parallel with the imaging plane of the lens 1 and perpendicular to the actual optical axis of the lens 1, so that the gap between the lower side face of the first connection part 21 and the second connection part 22 (the base) is consistent, and that the thickness of the glue filled between the first connection part 21 and the second connection part 22 is consistent and the shrinkage amount of the glue is consistent, which solves the problem of poor resolution power of the camera module caused by the inconsistent thickness of the glue filled between the first connection part 21 and the second connection part 22. On the other hand, when assembling the camera module of the present disclosure, after the correction plane 4 is arranged, the thickness of the glue filled between the correction plane 4 and the second connection part 22 is set in advance, that is, the thickness of the connection glue layer A is set in advance, so that it can be ensured that the thickness of the connection glue layer in each camera module is consistent, which is advantageous for solving the problems of poor product consistency and low pass rate.

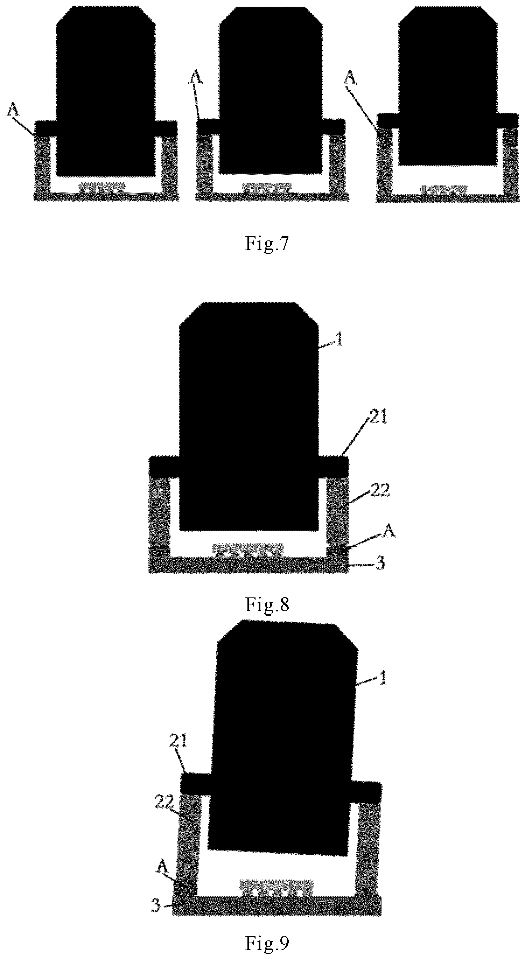

As shown in FIGS. 6 and 7, in addition to the deviation that the mechanical axis does not coincide with the actual optical axis, the lens 1 also has a deviation of the imaging plane. As shown in FIG. 6, a middle view of FIG. 6 indicates an ideal position of the imaging plane B of the lens 1, a left view indicates that the imaging plane B of the lens 1 has a negative deviation, and a right view indicates that the imaging plane B of the lens 1 has a positive deviation.

As shown in FIG. 7, when there is a negative deviation in the back focus of the lens 1, the thickness of the glue will decrease; the larger the deviation is, the smaller the thickness will be. When the deviation reaches a certain degree and the thickness of the glue is a negative value, it means that the lens 1 interferes with the base 22. At this time, due to the deviation in the back focus of the lens 1, the assembling of the camera cannot be carried out. When there is a positive deviation in the back focus of the lens 1, the thickness of the glue will increase; the larger the deviation is, the larger the thickness will be. When the thickness of the glue is too small, the gap between the lens 1 and the base 22 will be very small, which is very likely to cause interference during the AA process and assembly failure. If the thickness of the glue is too small, an adhesive force of the glue may not be enough, and the stability of the module is poor. When the thickness of the glue is too large, the AA gap between the lens 1 and the base 22 is large, so more glue is required to fill in the gap, resulting in a waste of the glue. In addition, if the gap of the glue is too large, the uniformity of the glue will be deteriorated and the stability of the module will be affected.

**Table 1**

| **Experimental Group No.** | **Glue thickness** | | **Glue shrinkage amount after UV exposure** | **Glue shrinkage amount after thermal curing** | **Overall glue shrinkage amount** | **Range of shrinkage amount** |
|---|---|---|---|---|---|---|
| 1 | 200um | 180um | 1.3um | 0.9um | 2.2um | 2.2∼4.6um |
| 2 | | 210um | 1.5um | 2.5um | 4.0um | |
| 3 | | 210um | 2.4um | 1.2um | 3.6um | |
| 4 | | 210um | 2.0um | 1.9um | 3.9um | |
| 5 | | 210um | 3.0um | 1.6um | 4.6um | |
| 6 | | 210um | 2.0um | 2.6um | 4.6um | |
| 7 | | 220um | 1.9um | 0.9um | 2.8um | |
| 8 | | 220um | 1.4um | 2.7um | 4.1um | |
| 9 | | 220um | 1.0um | 1.8um | 2.8um | |
| 10 | | 230um | 1.4um | 2.0um | 3.4um | |
| | | | | | | |
| 11 | 400um | 380um | 3.4um | 2.0um | 5.4um | 5.3-10.9um |
| 12 | | 380um | 2.5um | 2.8um | 5.3um | |
| 13 | | 390um | 4.0um | 4.3um | 8.3um | |
| 14 | | 390um | 2.4um | 5.0um | 7.4um | |
| 15 | | 390um | 3.2um | 2.1um | 5.3um | |
| 16 | | 400um | 5.3um | 5.4um | 10.7um | |
| 17 | | 400um | 5.8um | 5.1um | 10.9um | |
| 18 | | 400um | 2.9um | 4.3um | 7.2um | |
| 19 | | 420um | 3.2um | 3.1um | 6.3um | |
| 20 | | 420um | 3.1um | 4.5um | 7.6um | |
| | | | | | | |
| 21 | 600um | 570um | 3.2um | 4.9um | 8.1um | 6.9-15.4um |
| 22 | | 570um | 3.8um | 3.3um | 7.1um | |
| 23 | | 590um | 6.3um | 7.9um | 14.2um | |
| 24 | | 590um | 7.2um | 8.2um | 15.4um | |
| 25 | | 590um | 4.2um | 4.6um | 8.8um | |
| 26 | | 600um | 3.9um | 3.0um | 6.9um | |
| 27 | | 600um | 3.0um | 5.8um | 8.8um | |
| 28 | | 600um | 6.8um | 6.9um | 13.7um | |
| 29 | | 610um | 3.7um | 7.2um | 10.9um | |
| 30 | | 620um | 5.9um | 6.8um | 12.7um | |

On the other hand, as shown in Table 1, due to the different positions of the imaging planes of different camera modules, the thicknesses of the filled glues as required (the connection glue layers) are different, and the shrinkage amounts of the connection glue layers of different thicknesses are different during operation, so that the quality of the camera module cannot be guaranteed. Specifically, the larger the thickness of the glue is, the larger the shrinkage amount will be, and the larger the difference in the shrinkage amount will be. For the module described in the present disclosure, a focal depth range of the module is generally within a few microns. If the thickness of the glue is too large and the difference in the shrinkage amount is far larger than the focal depth range, then it cannot be ensured that the module will have good performance after the AA assembly.

As shown in FIGS. 1, 2 and 5, the camera module of the present disclosure aims to solve this problem; for all the camera modules, the thickness of the connection glue layer A is set as d, and d=F+h-H (i.e., F=H-h+d) is satisfied, where d represents the thickness of the connection glue layer A, F represents a distance from the correction plane 4 to the imaging plane, h represents a height of a photosensitive surface of the photoelectric imaging sensor from an upper surface of the circuit board 3, and H represents a height of the second connection part 22. Through such an arrangement, for different camera modules, the same d is set, and the h value and the H value of the second connection part 22 are measured respectively to find the position of the imaging plane, so that the position of the correction plane 4 can be found, that is, a removal amount of the second connection part 22 can be determined according to the above-mentioned formula (F=H-h+d). The camera module of the present disclosure can ensure that the thickness of the glue is consistent, and the thickness of the glue can be made very small, which is recommended to be below 200um. Of course, under the premise of ensuring the strength of the glue, the smaller the thickness is, the better it will be.

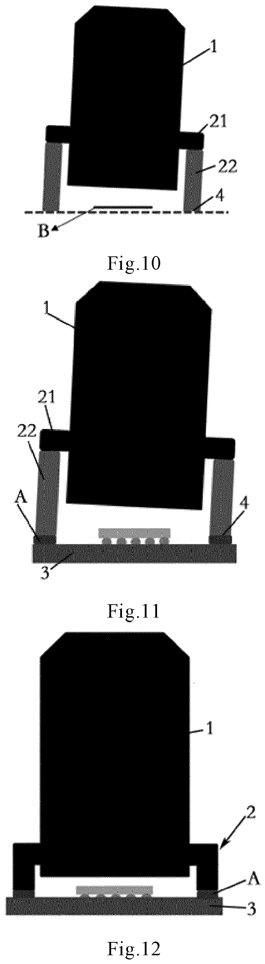

As shown in FIGS. 8 to 11, according to a second embodiment of the present disclosure, the first connection part 21 and the second connection part 22 of the connector 2 are both separate members. In this embodiment, the first connection part 21 is a connection flange and is fixedly connected with the lens 1, and the second connection part 22 is a base. In this embodiment, the lens 1, the first connection part 21 and the second connection part 22 are assembled first, and then assembled with the circuit board 3 through the AA process. As shown in FIG. 9, since the mechanical axis of the lens 1 does not coincide with the actual optical axis, the lens 1 needs to be set obliquely, so that the second connection part 22 assembled with the lens 1 is also set obliquely, thus resulting in different gaps between the second connection part 22 and the circuit board 3. Therefore, in this embodiment, a correction plane 4 is provided on a side of the second connection part 22 that faces the circuit board 3, that is, a lower side face of the second connection part 22 is the correction plane 4. The correction plane 4 is arranged parallel with an imaging plane B of the lens 1 and perpendicular to the actual optical axis of the lens 1, so that the gap between the second connection part 22 and the circuit board 3 is consistent, and that the thickness of the glue used to connect the second connection part 22 and the circuit board 3 is also consistent. In this embodiment, in order to avoid the influence of the back focus deviation of the lens 1 on the resolution power of the camera module, as shown in FIG. 10, a connection glue layer A is arranged between the correction plane 4 and the circuit board 3, and there exists d=F+h. Specifically, d represents the thickness of the connection glue layer A, F represents a distance from the correction plane 4 to the imaging plane, and h represents a height of a photosensitive surface of the photoelectric imaging sensor from an upper surface of the circuit board 3. In this embodiment, the correction plane 4 is located below the imaging plane, so F is a negative value. For all the camera modules, the thickness d of the connection glue layer A is the same. Therefore, for each camera module, the value of h can be measured first, and then F can be obtained according to F=d-h; then, the position of the correction plane can be found by taking the imaging plane as a reference; after this, the margin of the second connection part 22 is cut off by means of cutting or the like.

As shown in FIGS. 12 to 15, according to a third embodiment of the present disclosure, the first connection part 21 and the second connection part 22 of the connector 2 are integrally formed. In this embodiment, after the lens 1 and the connector 2 are assembled, they are assembled with the circuit board through the AA process.

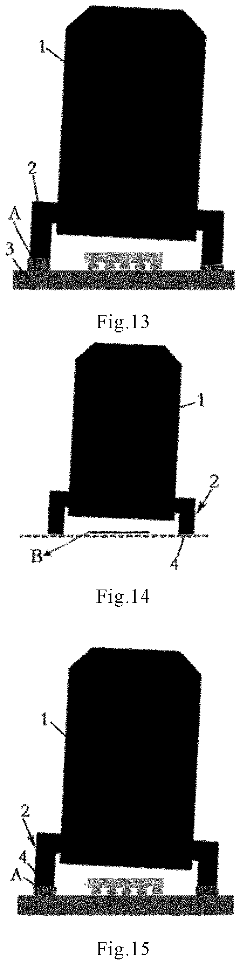

As shown in FIG. 13, since the mechanical axis of the lens 1 does not coincide with the actual optical axis, the lens 1 needs to be set obliquely, so that the second connection part 22 assembled with the lens 1 is also set obliquely, thus resulting in different gaps between the second connection part 22 and the circuit board 3. Therefore, in this embodiment, a correction plane 4 is provided on a side of the second connection part 22 that faces the circuit board 3, that is, a lower side face of the second connection part 22 is the correction plane 4. The correction plane 4 is arranged parallel with an imaging plane B of the lens 1 and perpendicular to the actual optical axis of the lens 1, so that the gap between the second connection part 22 and the circuit board 3 is consistent, and that the thickness of the glue used to connect the second connection part 22 and the circuit board 3 is also consistent. In this embodiment, in order to avoid the influence of the back focus deviation of the lens 1 on the resolution power of the camera module, as shown in FIG. 14, when part of the material of the second connection part 22 is cut along the dotted line in FIG. 14 to obtain the correction plane 4, the position of the correction plane 4 is determined according to the formula d=F+h (i.e., F=d-h).

The present disclosure also provides a method for assembling the above-described camera module, which includes the steps of: S1: assembling the lens with the connector having a size margin; S2: determining a height h of a photosensitive surface of the photoelectric imaging sensor from an upper surface of the circuit board; S3: setting the thickness d of the connection glue layer; S4: determining the imaging plane of the lens; and S5: according to the value of h obtained in the step S2 and the set value of d, and taking the imaging plane of the lens as a reference, performing material removal processing on the first connection part or the second connection part to obtain the correction plane which is a free end and which is parallel with the imaging plane, and fixing the first connection part and the second connection part through the connection glue layer or fixing the second connection part and the circuit board through the connection glue layer.

Specifically, according to an embodiment of the present disclosure, the assembling method of the present disclosure includes: measuring a height H of the second connection part, and assembling the circuit board and the second connection part into one component; measuring the height h of the photosensitive surface of the photoelectric imaging sensor from the upper surface of the circuit board; setting the thickness d of the connection glue layer; determining the imaging plane of the lens; according to the obtained H, h and d, and taking the imaging plane as a reference, performing material removal processing on the first connection part to obtain the correction plane which is parallel with the imaging plane, and making a distance F from the correction plane to the imaging plane be F=H+d-h; and fixedly connecting the correction plane of the first connection part and the second connection part through the connection glue layer.

According to a second embodiment of the present disclosure, the assembling method of the present disclosure includes: assembling the lens, the first connection part and the second connection part into one component, or selecting the first connection part and the second connection part as a connector of an integrally formed structure to form one component with the lens; measuring the height h of the photosensitive surface of the photoelectric imaging sensor from the upper surface of the circuit board; setting the thickness d of the connection glue layer; determining the imaging plane of the lens; according to the obtained h and d, and taking the imaging plane as a reference, performing material removal processing on the second connection part to obtain the correction plane which is parallel with the imaging plane, and making a distance F from the correction plane to the imaging plane be F=d-h; and fixedly connecting the circuit board and the correction plane of the second connection part through the connection glue layer.

It should be noted that the connection part of the present disclosure is provided with sufficient size margin. By sufficient size margin, it means that according to the concept of the present disclosure, for different camera modules, in case that the connection glue layer d is set to be consistent, regardless of what the optical axis deviation angle of the camera module and the position deviation of the imaging plane of the lens are, the corresponding correction plane can be found according to F=H+d-h or F=d-h, and then the material margin is removed to obtain the camera modules of the consistent glue thickness.

In the assembling method for the camera module of the present disclosure, the method of performing material removal processing on the first connection part or the second connection part to obtain the correction plane includes slicing, turning, cutting, milling or chemical etching.

Described above is only one embodiment of the present disclosure, which is not intended to limit the present disclosure. For those skilled in the art, various modifications and changes can be made to the present disclosure. Any modification, equivalent substitution, improvement or the like made within the spirit and principle of the present disclosure are intended to be included in the scope of protection of the present disclosure.

## Claims

1. A camera module, comprising a lens (1), a connector (2), a circuit board (3), and a photoelectric imaging sensor arranged on the circuit board (3); in the direction of an optical axis, the connector (2) comprises a first connection part (21) fixedly connected with the lens (1), and a second connection part (22) connected with the circuit board (3); wherein a correction plane (4) is provided on a side of the first connection part (21) that faces the second connection part (22), or a correction plane (4) is provided on a side of the second connection part (22) that is close to the circuit board (3); the correction plane (4) is parallel with an imaging plane of the lens (1), and a connection glue layer (A) of a predetermined thickness is provided between the correction plane (4) and the second connection part (22) or between the correction plane (4) and the circuit board (3).

2. The camera module according to claim 1, wherein the connection glue layer (A) is provided between the correction plane (4) and the second connection part (22), and there exists d=F+h-H;
where d represents the thickness of the connection glue layer (A), F represents a distance from the correction plane (4) to the imaging plane, h represents a height of a photosensitive surface of the photoelectric imaging sensor from an upper surface of the circuit board (3), and H represents a height of the second connection part (22).

3. The camera module according to claim 1, wherein the connection glue layer (A) is provided between the correction plane (4) and the circuit board (3), and there exists d=F+h;
where d represents the thickness of the connection glue layer (A), F represents a distance from the correction plane (4) to the imaging plane, and h represents a height of a photosensitive surface of the photoelectric imaging sensor from an upper surface of the circuit board (3).

4. The camera module according to claim 2, wherein the second connection part (22) is assembled with the circuit board (3), and the correction plane (4) is provided on the side of the first connection part (21) that faces the second connection part (22).

5. The camera module according to claim 3, wherein the first connection part (21) and the second connection part (22) are integrally formed, and the correction plane (4) is provided on the side of the second connection part (22) that is close to the circuit board (3).

6. The camera module according to claim 3, wherein the first connection part (21) is a lens flange, the second connection part (22) is a lens base, the lens (1) is assembled with the second connection part (22) through the first connection part (21), and the correction plane (4) is provided on the side of the second connection part (22) that is close to the circuit board (3).

7. An assembling method for the camera module according to any one of claims 1 to 6, comprising the steps of:
S1: assembling the lens with the connector having a size margin;
S2: determining a height h of a photosensitive surface of the photoelectric imaging sensor from an upper surface of the circuit board (3);
S3: setting the thickness d of the connection glue layer;
S4: determining the imaging plane of the lens; and
S5: according to the value of h obtained in the step S2 and the set value of d, and taking the imaging plane of the lens as a reference, performing material removal processing on the first connection part or the second connection part to obtain the correction plane which is a free end and which is parallel with the imaging plane, and fixing the first connection part and the second connection part through the connection glue layer or fixing the second connection part and the circuit board through the connection glue layer.

8. The assembling method according to claim 7, comprising:
measuring a height H of the second connection part, assembling the lens with the first connection part, and assembling the circuit board and the second connection part into one component;
measuring the height h of the photosensitive surface of the photoelectric imaging sensor from the upper surface of the circuit board (3);
setting the thickness d of the connection glue layer;
determining the position of the imaging plane of the lens;
according to the set d and the measured H and h, and taking the imaging plane as a reference, performing material removal processing on the first connection part to obtain the correction plane which is parallel with the imaging plane, and making a distance F from the correction plane to the imaging plane be F=H+d-h; and
fixedly connecting the correction plane of the first connection part and the second connection part through the connection glue layer.

9. The assembling method according to claim 7, comprising:
assembling the lens, the first connection part and the second connection part into one component, or selecting the first connection part and the second connection part as a connector of an integrally formed structure to form one component with the lens;
measuring the height h of the photosensitive surface of the photoelectric imaging sensor from the upper surface of the circuit board (3);
setting the thickness d of the connection glue layer;
determining the position of the imaging plane of the lens;
according to the set d and the measured h, and taking the imaging plane as a reference, performing material removal processing on the second connection part to obtain the correction plane which is parallel with the imaging plane, and making a distance F from the correction plane to the imaging plane be F=d-h; and
fixedly connecting the circuit board and the correction plane of the second connection part through the connection glue layer.

10. The assembling method according to claim 7, wherein the method of performing material removal processing on the first connection part or the second connection part to obtain the correction plane comprises slicing, turning, cutting, milling or chemical etching.
